# EUROPEAN PATENT SPECIFICATION

(11) **EP 4 345 471 B1**
(45) Date of publication and mention of the grant of the patent: **04.11.2026**
(21) Application number: 23193500.8
(22) Date of filing: 25.08.2023
(51) Int. Cl.: G01R 31/3842

(54) **SYSTEMS, APPARATUSES, AND METHODS FOR BATTERY MONITORING AND MANAGEMENT**
SYSTEME, VORRICHTUNGEN UND VERFAHREN ZUR BATTERIEÜBERWACHUNG UND -VERWALTUNG
SYSTÈMES, APPAREILS ET PROCÉDÉS DE SURVEILLANCE ET DE GESTION DE BATTERIE

(30) Priority: 28.09.2022 IN 202211055611
(43) Date of publication of application: 03.04.2024
(73) Proprietor: Honeywell International Inc., Charlotte, NC 28202 (US)
(72) Inventor: KISHORE, Kuna, Charlotte, 28202 (US)
(74) Representative: Haseltine Lake Kempner LLP

(56) References cited:
- CN-A- 111 274 539
- CN-U- 210 577 909
- KR-A- 20140 089 955
- HARB HASSAN ET AL: "Combining compression and clustering techniques to handle big data collected in sensor networks", 2018 IEEE MIDDLE EAST AND NORTH AFRICA COMMUNICATIONS CONFERENCE (MENACOMM), IEEE, 18 April 2018 (2018-04-18), pages 1 - 6, XP033353027, DOI: 10.1109/MENACOMM.2018.8371009
- PHILIPS W ET AL: "DATA COMPRESSION OF ECG'S BY HIGH-DEGREE POLYNOMIAL APPROXIMATION", IEEE TRANSACTIONS ON BIOMEDICAL ENGINEERING, IEEE, USA, vol. 39, no. 4, 1 April 1992 (1992-04-01), pages 330 - 336, XP000294416, ISSN: 0018-9294, DOI: 10.1109/10.126605

## Description

### TECHNOLOGICAL FIELD

Example embodiments of the present invention relate generally to batteries, and more particularly battery monitoring and management.

### BACKGROUND

Batteries are used in varied applications, including electric vehicles, power stations, backup systems, etc. Batteries in such applications may be monitored and managed by a battery management systems (BMS), which may also be referred to in some applications as an energy management system (EMS). A BMS may monitor a battery's state of charge and state of health and manage the usage of the battery. Application require a battery to provide power at one or more voltages, and a BMS may maintain cell balancing to achieve required voltage and current capacity. The amount of data generated by a BMS during battery's operational lifetime is huge, including data from a large number of sensors. However, the computing resources of a BMS are limited, particularly in view of requirements to process and store such large amounts of data. New methods in monitoring and managing such data, analyzing such data, and extracting useful insights from such data are needed. The inventor has identified numerous areas of improvement in the existing technologies and processes, which are the subjects of embodiments described herein. Through applied effort, ingenuity, and innovation, many of these deficiencies, challenges, and problems have been solved by developing solutions that are included in embodiments of the present disclosure, some examples of which are described in detail herein.

CN 210577 909 U concerns communication station backup power management.

### BRIEF SUMMARY

Various embodiments described herein relate to systems, apparatuses, and methods for battery monitoring and management.

Aspects of the invention are defined by the accompanying claims. According to a first aspect, there is provided a system in accordance with claim 1. According to a second aspect, there is provided a method in accordance with claim 5. According to a third aspect, there is provided a computer program product in accordance with claim 9. Advantageous optional features are defined in the dependent claims.

In accordance with some embodiments of the present disclosure, a system for battery monitoring and managing is provided. The system comprises a battery and a plurality of sensors electrically coupled to the battery and configured to generate sensor data associated with the battery. In some embodiments the plurality of sensors include at least a temperature sensor, a voltage sensor, and a current sensor, and the sensor data includes temperature sensor data generated by the temperature sensor, voltage sensor data generated by the voltage sensor, and current sensor data generated by the current sensor. In some embodiments the system further comprises a controller electrically coupled to the plurality of sensors, wherein the controller is configured to: receive sensor data from the plurality of sensors; compact the sensor data into coefficient data; generate one or more performance indicators based on the coefficient data; and generate at least one alarm based on the performance indicators.

In some embodiments, the controller is further configured to transmit the at least one alarm to a user interface and cause the alarm to be rendered on a user interface.

In some embodiments, the alarm is further based on one or more performance indicators exceeding a priority threshold.

According to the invention, the controller is configured to compact the sensor data into coefficient data is based on a polynomial equation.

In some embodiments, the performance indicators include a deviation rate.

In some embodiments, the battery is comprised of a plurality of battery modules, and wherein the plurality of sensors include a second plurality of sensors for each of the plurality of battery modules, wherein the second plurality of sensors include at least a temperature sensor, a voltage sensor, and a current sensor.

In some embodiments, the controller is further configured to: generate a table of performance indicators for display on a user interface; and render the table on the user interface.

In accordance with some other embodiments of the present disclosure, a method for battery monitoring and managing is provided. The method comprises: generating, with a plurality of sensors, sensor data associated with a battery, wherein the plurality of sensors are electrically coupled to the battery, wherein the plurality of sensors include at least a temperature sensor, a voltage sensor, and a current sensor, and wherein the sensor data includes temperature sensor data generated by the temperature sensor, voltage sensor data generated by the voltage sensor, and current sensor data generated by the current sensor; receiving, at a controller, the sensor data from the plurality of sensors; compacting the sensor data into coefficient data; generating one or more performance indicators based on the coefficient data; and generating at least one alarm based on the performance indicators

In some embodiments, the method further comprises: transmitting the at least one alarm to a user interface and cause the alarm to be rendered on a user interface.

In some embodiments, the alarm is further based on one or more performance indicators exceeding a priority threshold.

According to the invention, compacting the sensor data into coefficient data is based on a polynomial equation.

In some embodiments, the performance indicators include a deviation rate.

In some embodiments, the battery is comprised of a plurality of battery modules, and wherein the plurality of sensors include a second plurality of sensors for each of the plurality of battery modules, wherein the second plurality of sensors include at least a temperature sensor, a voltage sensor, and a current sensor.

In some embodiments, the method further comprises generating a table of performance indicators for display on a user interface; and rendering the table on the user interface.

In accordance with some other embodiments of the present disclosure, a computer program product for battery monitoring and managing is provided. The computer program product comprising at least one non-transitory computer-readable storage medium having computer-readable program code portions stored therein, the computer-readable program code portions comprising an executable portion configured to: receive, from a plurality of sensors, sensor data associated with a battery, wherein the plurality of sensors are electrically coupled to the battery, wherein the plurality of sensors include at least a temperature sensor, a voltage sensor, and a current sensor, and wherein the sensor data includes temperature sensor data generated by the temperature sensor, voltage sensor data generated by the voltage sensor, and current sensor data generated by the current sensor; receive, at a controller, the sensor data from the plurality of sensors; compact the sensor data into coefficient data; generate one or more performance indicators based on the coefficient data; and generating at least one alarm based on the performance indicators.

In some embodiments, the computer-readable program code portions comprising an executable portion are further configured to: transmit the at least one alarm to a user interface and cause the alarm to be rendered on a user interface.

In some embodiments, the alarm is further based on one or more performance indicators exceeding a priority threshold.

According to the invention, compacting the sensor data into coefficient data is based on a polynomial equation.

In some embodiments, the performance indicators include a deviation rate.

In some embodiments, the computer-readable program code portions comprising an executable portion are further configured to: generate a table of performance indicators for display on a user interface; and render the table on the user interface.

The foregoing brief summary is provided merely for purposes of summarizing some example embodiments illustrating some aspects of the present disclosure. Accordingly, it will be appreciated that the above-described embodiments are merely examples and should not be construed to narrow the scope of the present disclosure in any way. It will be appreciated that the scope of the present disclosure encompasses many potential embodiments in addition to those summarized herein, some of which will be described in further detail below.

### BRIEF SUMMARY OF THE DRAWINGS

Having thus described certain example embodiments of the present disclosure in general terms, reference will now be made to the accompanying drawings, which are not necessarily drawn to scale, and wherein:
FIG. 1 illustrates an example block diagram of a battery in accordance with one or more embodiments of the present invention;
FIG. 2 illustrates an example block diagram of a controller in accordance with one or more embodiments of the present invention;
FIGS. 3A, 3B, and 3C illustrate exemplary graphs demonstrating performance indicators in accordance with one or more embodiments of the present invention;
FIGS. 4A and 4B illustrate example displays in accordance with one or more embodiments of the present invention;
FIG. 5 illustrates a flowchart according to an example method for monitoring and managing batteries in accordance with one or more embodiments of the present disclosure;
FIG. 6 illustrates a flowchart according to an example method for compacting sensor data in accordance with one or more embodiments of the present disclosure; and
FIG. 7 illustrates a flowchart according to an example method for generating alarms in accordance with one or more embodiments of the present disclosure.

### DETAILED DESCRIPTION

Some embodiments of the present disclosure will now be described more fully herein with reference to the accompanying drawings, in which some, but not all, embodiments of the disclosure are illustrated. Indeed, various embodiments of the disclosure may be embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

The use of the term "circuitry" as used herein with respect to components of a system or an apparatus should be understood to include particular hardware configured to perform the functions associated with the particular circuitry as described herein. The term "circuitry" should be understood broadly to include hardware and, in some embodiments, software for configuring the hardware. For example, in some embodiments, "circuitry" may include processing circuitry, communication circuitry, input/output circuitry, and the like. In some embodiments, other elements may provide or supplement the functionality of particular circuitry.

The term "electronically coupled," "electronically coupling," "electronically couple," "in communication with," or "in electronic communication with," in the present disclosure refers to two or more elements, modules, circuitry, or components being connected through wired means and/or wireless means, such that signals, electrical voltage/current, data and/or information may be transmitted to and/or received from these elements or components.

The term "data object" and/or the like refer to a structured arrangement of data and/or electronically-managed data that is generated and/or maintained by a computing device (e.g., apparatus, computing device, or system or server of the present disclosure) and may be a collection of datum associated with the computing device. In various embodiments, data objects may contain data in one or more different formats, which may depend on the data and/or how the data was created.

### Overview

The present invention is related to battery monitoring and management. Batteries may be monitored and managed to promote safety and operational efficiency, particularly as greater numbers of industries continue to incorporate batteries into greater numbers of diverse applications, including electric vehicles and energy storage systems. The batteries used in different applications and/or industries may include different materials and be made according to different battery architectures. In use, batteries may be monitored and managed by a battery management system (BMS), including controlling how a battery may be used by a user and providing alarms to a user when a battery may be having an issue. The BMS may monitor and manage batteries based on input from one or more sensors associated with the batteries. When a battery is determined to have an issue (e.g., overheating, degrading performance, etc.), the BMS may control or modulate the power provided by a battery to a load. The BMS may also control a battery based on a prediction of battery health and/or indication of an anomaly, such as a violation of one or more priorities set for the battery, such as thresholds or ranges the battery is to operate within. To perform efficiently, the BMS of the present invention compacts large amounts of data associated with the batteries, and performance indicators are generated from the compacted data. The performance indicators are used to generate the alarms.

### Exemplary System or Apparatus

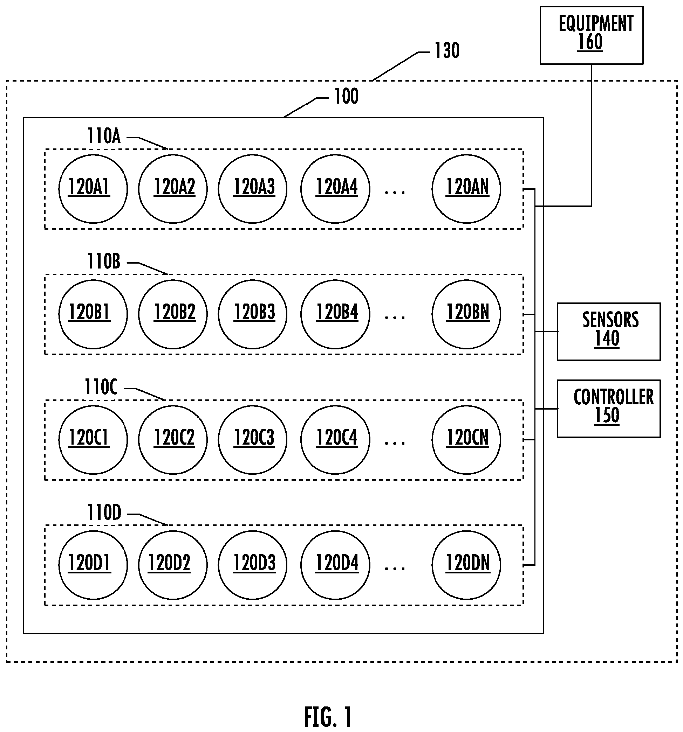

FIG. 1 illustrates an example block diagram of a battery 100 in accordance with one or more embodiments of the present invention. As illustrated, battery 100 may include a plurality of components or modules, including a plurality of battery modules 110. Each battery module 110 may include a plurality of battery cells 120. A battery 100 may be in a battery package 130 and be packaged with one or more sensors 140 and/or a controller 150. The sensors 140 and/or controller 150 may be electrically coupled to the battery 100, battery modules 110, and/or battery cells 120, including with additional connection not illustrated. The battery 100 may power one or more pieces of equipment 160.

Each battery cell 120 may store energy, such as through a chemical process, and may have an associated electric charge. The battery cells 120 may be connected in series, parallel, or a combination of series and parallel configurations to form a battery module 110 or a battery 100.

Each battery module 110 may include one or more battery cells 120. Thus each battery module 110 may be comprised of a plurality of individual battery cells 120. For example, battery module 110A may be comprised of battery cells 120A1, 120A2, 120A3, 120A4, through 120AN, where N is largest number of the battery cells 120 in the battery module 110A. Similarly, battery modules 110B, 110C, and 110D may respectively be comprised of battery cells 120B1-120BN, 120C1-120CN, and 120D1-120DN. In various embodiments, additional battery modules 110 (e.g., 110E - 110N) may be similarly respectively comprised of battery cells 120 (e.g., 120E1-120EN, 120N1-120NN).

While not illustrated, the battery cells 120 of a battery module 110 (e.g., battery cells 120A1, 120A2, 120A3, 120A4, ..., 120AN) may be electrically connected or coupled in series, in parallel, or in series/parallel. The configuration of these connections may be to connect the battery cells 120 to configure a battery module 110 with a specific output voltage and output current.

A battery 100 may be comprised of a plurality of battery modules 110. While only one configuration is illustrated, each of the battery modules 110 may be electrically connected or coupled in series, in parallel, or in series/parallel. The configuration of these connections may be to connect the battery modules 110 to configure a battery 100 with a specific output voltage and output current.

Such series, parallel, and series/parallel configurations of battery cells 120 and also battery modules 110 respectively allow for each battery module 110 and battery 100 to have a specific voltage and to provide a current at specific voltage. Monitoring sensor data, including but not limited to temperature, voltage, and current, allows for identifying battery 100 performance and degradation. Monitoring may be done in real time or it may be done at discrete time intervals.

As sensor data from sensors 140 is generated, the sensor data may be tagged with additional data, such as a cycle identifier associated with a charge cycle or discharge cycle as well as an identifier of a battery 100, battery module 110, and/or battery cell 120 associated with the sensor data. The sensor data may be stored in a data object, such as a sensor data object.

In various embodiments, the sensors 140 and/or controller 150 may be included in the battery package 130 or separate from the battery package 130. For example, in various embodiments related to electric vehicles, a plurality of sensors 140 and one or more controllers 150 may be packaged with a battery 100 in a battery package 130. As another example, in various embodiments related to energy storage, a plurality of sensors 140 and one or more controllers 150 may be located externally to a battery 100 or battery package 130. The form of the battery pack 130 may depend on the application that the battery 100 is used in. For example, electric vehicles may have the battery 100 enclosed in a protective battery pack 130 designed for use in an automobile and resistant to the shocks, temperatures, and impacts that may occur during operation of the automobile. In an alternative example, battery packs in an energy station or home installation applications may be packaged differently, such as to allow for additional cooling without the need to protect from shocks or impacts. Some or all of a sensor 140 and/or controller 150 may be located separately from the battery pack 130, which may be based on the application of the battery 100.

Sensors 140 may be electrically coupled or connected to a battery 100, battery module 110, and/or battery cells 120. Sensors 140 may include temperature sensors, voltage sensors, current sensors, charge sensors, pressure sensors, chemical sensors, gas sensors, and the like. The sensors 140 may be configured to obtain at least one measurement associated with the sensors type (e.g., a temperature sensor may be configured to measure the temperature and/or a change in temperature over time, etc.). The sensors 140 may also be configured to transmit a measurement to a controller 150. In various embodiments, the controller 150 may provide a control signal or indication to control a battery 100, battery module 110, or battery cell 120 based on the sensor data received from sensors 140.

A battery pack 130 may include all or part of a sensor 140. The number and type of sensors 140 may be different based on the battery architecture of the battery 100. Sensors 140 may include, among others, current sensors, voltage sensors, temperature sensors, charge sensors, pressure sensors, and/or force sensors. While embodiments disclosed herein may generally include current, voltage, and temperature measurements from respective sensors 140, it will be readily appreciated that the measurements from different sensors may each be applied in a like manner disclosed herein, including using a polynomial equation to relate sensor measurements.

The one or more equipment 160 powered by the battery 100 depending on the application the battery 100 is being used in. In various embodiments, the equipment 160 may be an electrical vehicle that includes multiple components and subsystems powered from one battery 100, which may be made of multiple battery modules 110. In other various embodiments the equipment 160 may be an energy station, and the connection to the equipment may be to a power distribution network or bus that may transmit power from the battery 100 to one or more devices.

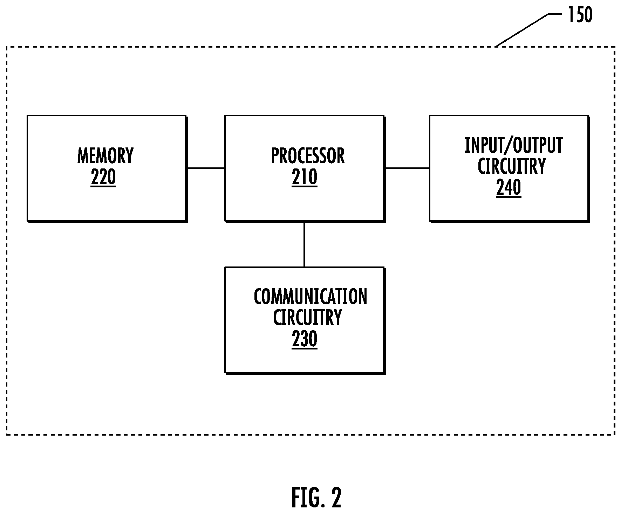

FIG. 2 illustrates an example block diagram of a controller 150 in accordance with one or more embodiments of the present invention. As illustrated, the embodiment of controller 150 may comprise a processor 210, memory 220, communication circuitry 230, input/output circuitry 240, and/or other components configured to perform various operations, procedures, functions, or the like. While not illustrated in FIG. 2, the processor 210 may be electrically connected to one or more sensors 140, and such a connection may allow for the controller 150 to receive and/or transmit data to the one or more sensors 140.

The processor 210, although illustrated as a single processor 220, may be comprised of a plurality of components and/or processor circuitry. The processor 210 may be implemented as, for example, various devices comprising one or a plurality of microprocessors with accompanying digital signal processors; one or a plurality of processors without accompanying digital signal processors; one or a plurality of coprocessors; one or a plurality of multi-core processors; processing circuits; one or a plurality of computers; and various other processing elements (including integrated circuits, such as ASICs or FPGAs, or a certain combination thereof). In various embodiments, the processor 210 may be configured to execute instructions and/or programs stored in the memory 220 or otherwise accessible by the processor 210. When executed by the processor 210, these instructions and/or programs may enable the controller 150 to execute one or a plurality of the operations and/or functions described herein. Regardless of whether it is configured by hardware, firmware/software methods, or a combination thereof, the processor 210 may comprise entities capable of executing operations and/or functions according to the embodiments of the present invention when correspondingly configured. Therefore, for example, when the processor 210 is implemented as an ASIC, an FPGA, or the like, the processor 210 may comprise specially configured hardware for implementing one or more operations and/or functions described herein. Alternatively, as another example, when the processor 210 is implemented as an actuator of instructions (such as those that may be stored in the memory 220), the instructions may specifically configure the processor 210 to execute one or more operations described herein.

The memory 220 may comprise, for example, a volatile memory, a non-volatile memory, or a certain combination thereof. Although illustrated as a single memory in FIG. 2, the memory 220 may comprise a plurality of memory components. In various embodiments, the memory 220 may comprise, for example, a hard disk drive, a random access memory, a cache memory, a flash memory, an optical disk, a circuit configured to store information, or a combination thereof. The memory 220 may be configured to store data, information, application programs, instructions, etc., so that the controller 150 can execute various operations and/or functions according to the embodiments of the present disclosure. For example, in at least some embodiments, the memory 220 is configured to cache data for processing by the processor 210. Additionally or alternatively, in at least some embodiments, the memory 220 is configured to store program instructions for execution by the processor 210. The memory 220 may store information in the form of static and/or dynamic information. When the operations and/or functions are executed, the stored information may be stored and/or used by the controller 150.

The communication circuitry 230 may be implemented as any apparatus included in a circuit, hardware, computer program product, or a combination thereof, which is configured to receive and/or transmit data from/to another component or apparatus. The computer program product may comprise computer-readable program instructions stored on a computer-readable medium (e.g., memory 220) and executed by a controller 150 (e.g., processor 210). In various embodiments, the communication circuitry 230 (as with other components discussed herein) may be at least partially implemented as part of the processor 210 or otherwise controlled by the processor 210. The communication circuitry 230 may communicate with the processor 210, for example, through a bus. Such a bus may connect to the processor 210, and it may also connect to one or more other components of the controller 150. The communication circuitry may be comprised of, for example, antennas, transmitters, receivers, transceivers, network interface cards and/or supporting hardware and/or firmware/software, and may be used for establishing communication with another system, apparatus, and/or component. The communication circuitry 230 may be configured to receive and/or transmit any data that may be stored by, for example, the memory 220 by using any protocol that can be used for communication between components and/or apparatuses. In various embodiments, the communication circuitry 230 may transform or package data to be transmitted and/or transform or unpackage data received, such as from a first communication protocol to a second communication protocol or from a first data type to a second data type. The communication circuitry 230 may additionally, or alternatively, communicate with the memory 220, the input/output circuitry 230 and/or any other component of the controller component 150, for example, through a bus.

The input/output circuitry 240 may communicate with the processor 210 to receive instructions input by a user and/or to provide audible, visual, mechanical, or other outputs to a user. The input/output circuitry 240 may comprise supporting devices, such as a keyboard, a mouse, a user interface, a display, a touch screen display, lights (e.g., warning lights), indicators, speakers, and/or other input/output mechanisms. In various embodiments, aspects of the input/output circuitry 240 may be implemented on a device used by the user to communicate with the controller 150. The input/output circuitry 240 may communicate with the memory 220, the communication circuitry 230, and/or any other component, for example, through a bus.

Operation of the battery 100 may be controlled by controller 150. Operations may include charging and/or discharging the battery 100. The process of charging a battery over a period of time may be referred to as a charge cycle or charging cycle, and the process of discharging a battery over a period of time may be referred to as a discharge cycle or discharging cycle. In various embodiments, the life of a battery 100 is to switch between charge cycles and discharge cycles as the battery 100 is charged and then discharged to provide power to a load.

During charging and discharging cycles a battery 100 may generate heat, which may damage or degrade a battery 100, battery module 110, or battery cell 120 over time. The heat generated may be measured, such as by a temperature sensor 140. In various embodiments, the damage or degradation may be due to the rate of charge and/or rate of discharge, which may change between charge cycles and discharge cycles. High rates of charge and discharge may place stress on the battery, such with generating larger amounts of heat.

Charging and discharging, including at various rates, involves the application of voltage and current to the battery 100 or to a load. The heat generated during charging and discharging may be related to the voltage and current empirically, such as with a polynomial equation. Temperature, voltage, and current may be measured with the sensors 140.

The sensor data generated from sensors 140 may be in a structured format, such as in a sensor data object. The sensor data object may include the sensor data alone or along with one or more tags added to tag the sensor data after it has been generated. Tagging the sensor data may include adding data related to an identifier of the battery 100, battery module 110, or battery cell 120 being measured, a sensor 140 identifier, a time, a charge cycle, a discharge cycle, etc.

In various embodiments, the tagging of sensor data may also be used to monitor a sensor 140, such as determining if a sensor 140 has been damaged or is going bad. In various embodiments, if sensor data over consecutive cycles or over time is outside one or more thresholds or ranges consistently, this may be indicative of an error with a sensor 140. Such an error may generate an alarm as described herein.

Sensor data may be generated by sensors 140 continuously or at time intervals. In various embodiments, an interval may be related to a cycle. A charge cycle may be determined to begin based on sensor data. For example, a charge cycle the sensor data may indicate current is flowing into the battery and may also indicate that voltage is going up, and for a discharge cycle, the sensor data may indicate current is flowing out of the battery and may also indicate that voltage available is going down. In such an example the sensor data from one or more sensors 140 may be used to determine when a charge or discharge cycle starts or, similarly, ends. Additionally, or alternatively, the determination of a charge or discharge cycle may also be based on receiving data from a charger or external system or apparatus that a charging cycle has begun, such as with communication circuitry 230. Additionally, or alternatively, the determination of a charge or discharge cycle may also be based on sensing a charger connector or charging connection, such as with input/output circuitry 240, which in various embodiments may be sensed from a physical switch being operated. The sensor data generated may be formatted into a sensor data object and/or tagged with additional information or data, which may be associated with a cycle or interval.

The sensor data may be used to monitor and control the battery 100. In various embodiments, battery architectures may include self-balancing batteries that are monitored and managed with the controller 150. For example, a battery 100 with a plurality of battery modules 110 may include a controller 150, if the controller 150 determines that a first battery module 110A is outputting a current and/or voltage different from a second battery module 110B, the controller 150 may adjust the output of each battery module 110A and 110B to balance the power being provided from each battery module 110. This may include actuating one or more switches in the battery 100, battery modules 110A, 110B and/or battery cells 120AN, 120BN. In various embodiments this may include switching one or more battery cells 120AN of battery module 110A on or off or switching how the battery cells 120AN of battery module 110A are connected in the battery module 120A. By controlling one or more configurations of how battery cells 120 and/or battery modules 110 are connected, the controller 150 may balance the battery 100.

The controller 150 may include operations or functionality to switch between how the individual battery cells 120 may be connected. A battery cell 120 may have one or more associated switches that may, for example, connect or disconnect the battery cell 120. In various embodiments, such switches may be comprised of one or more transistors, such as MOSFETs. Thus, for example, if one or more battery cells 120 is determined to malfunction or be associated with an alarm, the battery cell(s) 120 may be disconnected or bypassed. Control of such switches may be through an operation executed by the controller 150.

In various embodiments, there may be a controller 150 for the battery 100 (a.k.a. a battery controller 150) and also separate controllers 150 for each of the battery modules 110 (a.k.a. battery module controller(s) 150). The one or more battery module controllers 150 may be electrically coupled to the battery controller 150, and the battery controller 150 may provide one or more signals and/or instructions to a battery module controller 150 to control operations of the battery module 110, such as operating one or more switches, including connecting and/or disconnecting one or more battery cells 120.

In various embodiments self-balancing batteries may operate the balancing to minimize stress on the batteries, including controlling temperature rise in the battery 100, battery modules 110, and/or battery cells 120. The temperature of a battery 100, battery modules 110, and/or battery cells 120 may be monitored with a temperature sensor 140, which may generate temperature data that may be transmitted to the controller 150. In addition to the temperature data, the sensors 140 may include a voltage sensor 140 and a current sensor 140, both of which may provide voltage data and current data, respectively, to the controller 150. In various embodiments, the temperature data, voltage data, and/or current data may be provided continuously, at specific times or time intervals, on exceeding a threshold, and/or on deviating from a range.

In various embodiments, a sensor data object containing temperature data, voltage data, and current data for a plurality of batteries 100, battery modules 110, and/or battery cells 120. As an illustrative example, sensor data from a temperature sensor, voltage sensor, and current sensor for each of 10 battery modules 120 may produce a data stream of temperature, voltage, and current measurements over time to be stored of:
{[T,V,I]₁, [T,V,I]₂, . . ., [T,V,I]ₙ}ₜ₁, . . ., {[T,V,I]₁, [T,V,I]₂, . . ., [T,V,I]ₙ}ₜₘ
T is temperature data of a temperature measurement;
V is voltage data of a voltage measurement;
I is current data of a current measurement;
n is the number of the battery module 120 (which in this example is from 1 to 10); and
t is a time period from s start time (e.g., t = 1) to an end time of m.

Sensor data objects containing such sensor data of measurements from sensors 140 may be transmitted from the sensors 140 to the controller 150. From such measurements of temperature, voltage, and current, a controller 150 may monitor a battery 100, battery module 110, and/or battery cell 120 for performance and safety, including maximizing the life of the battery 100, alarm for possible failures, and control the battery 100, battery modules 110, and/or battery cells 120.

Monitoring and managing of the battery 100 from temperature, voltage, and current measurements may be based on one or more reference measurements established during the design and/or manufacture of a battery 100, battery modules 110, and/or battery cell 120. There may be reference measurement for a charge cycle and reference measurements for discharge cycle. Such reference measurements may be specific to the architecture of the battery 100, battery modules 110, and/or battery cells 120, and a battery 100 may include a plurality of battery modules 110 and a plurality of battery cell 120, some of which that may be of different architectures than others. In embodiments with different architectures, the monitoring and control may be done at the component level implementing the different architectures.

The sensors 140 generate a large amount of sensor data during operation. In monitoring and managing batteries 100, the present invention improves on conventional battery monitoring and management systems and apparatuses by, among other things, addressing this large amount of data generated. As described herein, the present invention compacts the sensor data into coefficient data, which reduces the amount of data for the controller 150 to process, store, and transmit. Such a reduction improves processing and operation efficiency by cutting down on the amount of data to be processed, stored, and transmitted. Moreover, the compacting of such sensor data further allows for improved insights and alarms to be generated. Improvements also include generating performance indicators that are further used to determine alarms and generate alarm signals.

Data compacting uses sensor data of each time interval, which may be referred to as temporal sensor data. In various embodiments, the generation and receipt of temporal data may be continuous in real-time, continuous with a delay (e.g., a fixed time delay, delay based on query of sensor, etc.) or at discrete periods of time (e.g., sample intervals). The data compacting takes the sensor data received by the controller 150 and compacts the data into a small number of coefficients, which may be stored as coefficient data in a coefficient data object instead of the large number of measurements in the sensor data.

The coefficients are the coefficients of a polynomial equation that represents the behavior of the battery 100. While various embodiments disclosed herein describe a second order polynomial equation, it is readily appreciated that higher order (e.g., 3rd, 4th, 5th, etc.) polynomial equation are included within the scope the present invention. A higher order polynomial equation would include additional coefficients.

In various embodiments, a polynomial equation equates temperature to a function of voltage and current. The following is an example of such a second order polynomial equation: $T \left|{t}_{m}\right. = \left\{{C}_{p}\left({I}^{2}{V}^{2}\right)+{C}_{p - 1}\left({I}^{2}V\right)+{C}_{p - 2}\left({IV}^{2}\right)+{C}_{p - 3}\left(IV\right)+{C}_{p - 4}\left(I\right)+{C}_{p - 5}\left(V\right)+{C}_{0}\right\} {t}_{m}$
T is temperature;
V is voltage;
I is current;
t is time period m;
Cₚ is a coefficient of I²V²;
Cₚ₋₁ is a coefficient of I²V;
Cₚ₋₂ is a coefficient of IV²;
Cₚ₋₃ is a coefficient of IV;
Cₚ₋₄ is a coefficient of I;
Cₚ₋₅ is a coefficient of V; and
C₀ is a constant.

As is readily seen, the second order polynomial includes 6 coefficients and a constant. When addressing this second order polynomial herein the phrase coefficients collectively refers to these 6 coefficients and constant unless otherwise specified. Coefficient data comprised of these coefficients may be referred to as compacted sensor data as the coefficient data represent all of the sensor data compacted into these coefficients.

The above second order polynomial equation may be solved by controller 150 based on the sensor data received. This may include inserting a temperature measurement for T, a voltage measurement for V, and a current measurement for I. In various embodiments, the solving of a polynomial equation may include solving it for a specified error rate, which may be predefined. For example, 5%. Alternatively, or additionally, an error rate may be set or adjusted by a user, such as via the input/output circuitry 240. Solving the polynomial may involve iterative calculations being performed to determine the coefficients. Solving for the coefficients may occur in real-time as new sensor data is received or at regular time intervals, such as at the end of a charge or discharge cycle. Sensor data may be received in various formats, such as in separate data objects or in one data object. In various embodiments, sensor data objects with sensor 140 measurements may be generated and transmitted to a controller 150 at regular time intervals or continuously.

In solving for the coefficients, a controller may generate the coefficients and store them in a coefficient data object once solved for. In various embodiments there are different coefficients for charging and for discharging and, thus, charging coefficients may be generated as may be discharging coefficients, which may respectively be stored in charging coefficients data object(s) and discharging coefficient data object(s). An example of the charging coefficient data for a cycle z may be: $CHG_Coeff \left(z\right) = \left[Cp, Cp-1, Cp-2………C1, C0\right]$

As the coefficients only need to be generate for a charge cycle, or a discharge cycle, the charging coefficient data and discharging coefficient data is much smaller than the sensor data generated by the sensors 140 and used to determine the coefficient data. Once coefficient data for a charging or discharging cycle is generated, the sensor data may be deleted, disregarded, or overwritten. Thus the present invention may improve on conventional battery monitoring and management systems which may store such sensor data, which may limit conventional battery monitoring and management systems.

The coefficient data for a charging cycle and the coefficient data for a discharging cycle allow for analysis of battery performance, including through the generation of performance indicators. The performance indicators may be based on a set of reference coefficients. In various embodiments, the reference coefficients are related to an expected or standard performance of the battery 100, battery modules 110, and/or battery cells 120. The set of reference coefficients for charging cycles and discharging cycles may be determined during manufacturing and/or calibration, and the reference coefficients may vary for different in architectures of batteries 100, battery modules 110, and battery cells 120. It is also readily appreciated that reference coefficients change based on the order of the polynomial equation used. In various embodiments, the controller 150 addresses each of these different sets of coefficients and reference coefficients in turn.

During operation, sensor data may be received at time intervals (e.g., t1, t2, t3, etc.), and the polynomial equation may be solved for by the controller 150 at each time interval or after all intervals associated with a cycle are received. To generate coefficient data for a cycle, the sensor data for each time interval may be averaged, such as being averaged over time. For example, C_{P} of time t₁ will be averaged with C_{P} of time t₂ and with C_{P} of time t₃ and so on for each interval. Such averaging may be done for each of the coefficients. The averaging may occur until each coefficient has been averaged.

In various embodiments the averaging may be a moving average and/or a time weighted averaging, particularly if each of the sensor 140 measurements are not taken at the same time, such as if a cycle does not end at the end of a time interval. In various embodiments, the time interval may be different as the time to charge or discharge a battery 100 may be different, which may depend on the application using the battery. For example, different battery chargers may charge a battery 100 at different rates. Also, different applications may discharge the battery 100 at different rates (e.g., driving an electric vehicle slow leading to a slower discharge than driving an electric vehicle fast leading to a faster discharge due to the greater load being placed on the battery).

As another example, in various embodiments a charging cycle may be 10 minutes and sensor data may be taken in time period intervals of 1 minute. Thus a charging cycle lasting 10 minutes may have 11 sensor data samples, including 1 at time equal to zero at the beginning of the charge cycle and one at time equal to 10 minutes at the end of the charge cycle. Thus temperature data, current data, and voltage data are generated 11 times, for a total of 33 data points for each battery 100, battery module 110, and/or battery cell 120 being monitored. As the number of batteries 100, battery modules 110, and/or battery cells 120 increases, the number of data points increases. This present invention, however, reduces the data to only the coefficient data.

The coefficient data may be utilized with the reference coefficient data to generate the coefficient data into performance indicators associated with each of the coefficients. Performance indicators may be associated with the performance of battery 100, battery module 110, and/or battery cell 120. For example, each may be designed and have a certain number of charge cycles and discharge cycle. In various embodiments, this may be 2000 charge cycles and 2000 discharge cycles. Such numbers of charge cycles and discharge cycles may determine a design life span of the battery 100, battery modules 110, and/or battery cells 120. Performance indicators may be used to indicate how a battery 100 performs over its design life span.

Moreover, the coefficients of the polynomial equation relate to battery behavior or the physics of the battery 100, battery module 110, and/or battery cells 120. Additionally, or alternatively, the coefficients may capture the behavior of the battery 100, battery modules 110, and/or battery cells 120 during the cycle. For example, and using the second order polynomial, the Cₚ coefficient of Q²V² relates to power loss from the fast charging of the battery. As a further example, the coefficient Cp-1 relates to heat loss during steady state charging.

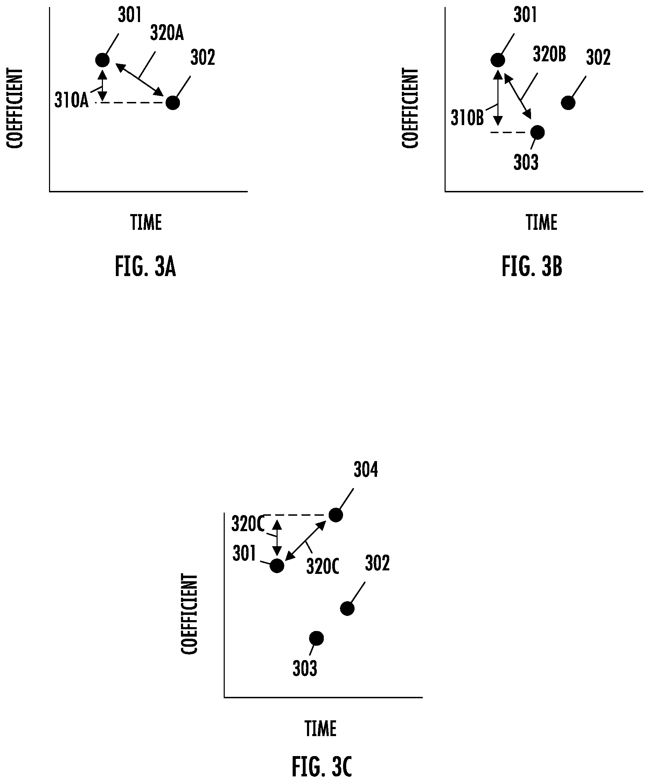

Each coefficient of the coefficient data are processed to generate one or more performance indicators. In particular, three performance indicators are used for each coefficient, and these performance indicators are variance, slope, and deviation rate. The performance indicators of variance and slope are also described herein regarding FIGS. 3A, 3B, and 3C.

Variance is a relative distance between a coefficient for a cycle and the associated reference coefficient. Variance may be determined by subtracting the reference coefficient from the coefficient for a cycle: $Variance = {C}_{p} - {C}_{p , r}$
Cₚ is a coefficient; and
C_{p,r} is the corresponding reference coefficient.

Slope is determined from two successive time intervals of a coefficient and a reference coefficient with the following equation: $Slope = \left({C}_{p}-{C}_{p , r}\right) {t}_{m} / \left({t}_{m}-{t}_{r}\right)$
Cₚ is a coefficient; and
C_{p,r} is the corresponding reference coefficient;
tₘ is a time, such as in hours, to complete a cycle m; and
tᵣ is a time to complete the reference cycle.

As slope is determined from two successive cycles, the slope is not determined for the first charge cycle or the first discharge cycle.

Deviation rate (DR) is the relative change of variance from successive charge cycles or discharge cycles (e.g., from a second charge cycle and a first charge cycle, or from a second discharge cycle and a first discharge cycle). DR may be determined with the following equation: $DR = sqrt \left({\left(X-Y\right)}^{2}/{\left(A-B\right)}^{2}\right)$
X is the variation between two successive cycles (e.g., cycle 1 and cycle 2);
Y is the variation between two other successive cycles following the cycles of X (e.g., cycle 3 and cycle 4);
A is a time that is the time between the two successive cycles of X; and
B is a time that is the time between the two other successive cycles of Y.

The DR is the relative change of this variance between time lapse between the charge discharge cycle. It may be indicative of how fast a battery 100, battery modules 110, and/or battery cells 120 degrade per unit time compared to other cycles. Deviation rate relates to how the slope may be changing between the two successive charge cycles or discharge cycles.

FIGS. 3A, 3B, & 3C illustrate exemplary graphs demonstrating performance indicators in accordance with one or more embodiments of the present invention. In particular, FIGS. 3A, 3B, and 3C demonstrate the performance indicators of variance and slope for, respectively, a first coefficient associated with a first cycle, a second coefficient associated with a second cycle, and a third coefficient associated with a third cycle.

FIG. 3A illustrates a graph of time on the horizontal axis and a coefficient value on the vertical axis graphing a reference coefficient value 301 and a first coefficient value 302. The variance for the first coefficient value 302 and reference coefficient value 301 as calculated above is illustrated at variance 310A. The slope for the first coefficient value 302 and reference coefficient value 301 as calculated above is illustrated at variance 320A.

FIG. 3B illustrates the graph of FIG. 3A with the addition of a second coefficient value 303. As a new, second coefficient is determined for a second cycle, a new, second variance and slope are determined for this second cycle. The variance for the second coefficient value 303 and reference coefficient value 301 as calculated above is illustrated at variance 310B. The slope for the second coefficient value 303 and reference coefficient value 301 as calculated above is illustrated at variance 320B.

FIG. 3C illustrates the graph of FIG. 3B with the addition of a third coefficient value 303. As a new, third coefficient is determined for a third cycle, a new, third variance and slope are determined for this third cycle. The variance for the third coefficient value 304 and reference coefficient value 301 as calculated above is illustrated at variance 310C. The slope for the third coefficient value 304 and reference coefficient value 301 as calculated above is illustrated at variance 320C.

As is readily appreciated, the generation of variation and slope may occur as additional cycles are completed and new coefficient data is generated.

The present invention generates insights from the performance indicators, particular as the performance indicators for a coefficient for recent cycles are compared to the performance indicators for the coefficient of previous cycles, including generating alarms. The insights that may be generated are described in view of displays that may be generated for a user.

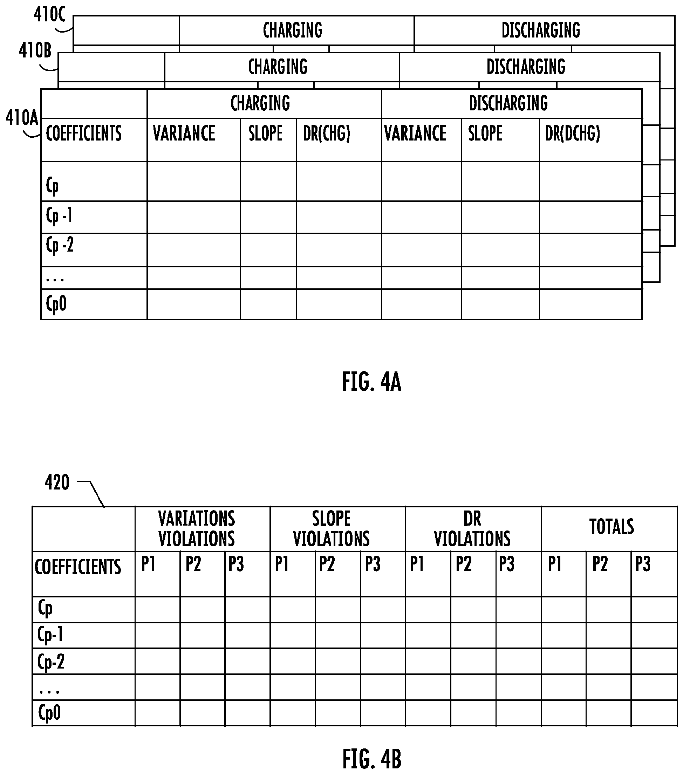

FIGS. 4A & 4B illustrate example displays in accordance with one or more embodiments of the present invention. FIG. 4A illustrates a display of coefficients and performance indicators over time by using a plurality of tables for each of the charging and discharging cycles that occurs over time. FIG. 4B illustrates a display of coefficients in view of violations of priorities. In various embodiments, priorities may be thresholds or ranges. Each of the displays of FIGS. 4A & 4B, or variations of them, may be generated by a controller 150 and presented to a user by rendering the display on a user interface (e.g., display, touchscreen display, etc.) of input/output circuitry 240.

FIG. 4A illustrates a three dimensional table may be utilized to display on the first, vertical axis the coefficients, a second, horizontal axis the performance indicators, and on a third axis (e.g., into the figure) the values of the first and second axes at different cycles or times. The table 410A is at the first time, the table 410B is at the second time, and the table 410C is at the third time. With such a three dimensional table a user may be able to quickly query the performance indicators for each of the coefficients across time.

FIG. 4B illustrates a table 420 that may be progressively built or updated in real time as additional sensor data is received, coefficients are generated, and performance indicators are generated. FIG. 4B may be utilized to display on the first, vertical axis the coefficients. On the second, horizontal axis the table presents how each performance indicator may have violated one or more priorities or priority thresholds, which may be referred to as P1, P2, and P3, as well as how many total violations of these priorities there have been across the performance indicators.

In various embodiments, the tables of FIG. 4A and FIG. 4B may be linked such that a user may interact with a table (e.g., via a touchscreen user interface, etc.) and have the other table presented, including emphasis (e.g., highlighting, underlining, font color change) that may indicate how the first table presented linked to the second table.

A priority may be threshold or a range for a value of a coefficient, and the priority may be different for each coefficient. The thresholds and/or ranges associated with a priority may be predefined, such as by a manufacturer. Alternatively, or additionally, a user may set or change the thresholds through a user interface of input/output circuitry 240. For example, a user may set one or more priorities or a user may set a priority value and then additional ranges may be determined based on that priority. In various embodiments, a user may not be an end user but may be, as described herein, a manufacturer of a battery 100 or of an application utilizing a battery 100 (e.g., an electric vehicle, energy storage, etc.). A first priority P1 may be set to less than 10% greater than the priority value, a second priority P2 may be set to between 10%-50% greater than the priority value, and a third priority P3 may be set to greater than 50% greater than the priority value. When a performance indicator of a coefficient violates a priority threshold, such as being between 10-50% greater than the set priority value then the value for that performance indicator for P2 may be incremented. As violations occur, the total of all types of violations may be determined.

As violations increase, alarms may be generated. In various embodiments alarms may be broken into three categories of increasing importance: warnings, alerts, and stops. A warning may indicate something out of the ordinary occurred. An alert may indicate a possibility of an upcoming failure. A stop may indicate that the battery 100, battery modules 110, and/or battery cells 120 should stopped being used and/or associated equipment 160 drawing power from the battery 100 should stopped being used. Based on such alarms a controller 150 may control a battery 100, battery module 110, and/or battery cells 120, including generating one or more signals to stop providing power and/or to control the battery 100 or associated equipment 160.

The alarms of warnings, alerts, and stops may be determined based on one or more thresholds and/or ranges, which may be absolute values or percentages. Additionally, or alternatively, combinations including how each of the performance indicators violate a priority may be used to generate an alarm.

For example, in various embodiments a warning may occur after 10 occurrences of the variation deviation from the threshold, such as exceeding a threshold.

In another example, 8 occurrences of a slope violating a first priority and 3 occurrences of DR violating a second priority may generate an alarm.

Additionally, or alternatively, a violation of one performance indicator may take priority over the violation of a priority of another performance indicator. For example, in various embodiments, violations of priorities for DR make take precedence over variance or slope, and violations of priorities of slope may take precedence over variance. As another example, each of variance, slope, and DR may each be associated with multiple priorities-a first priority (e.g., less than 10%) and a second priority (e.g., greater than 10%). Violation of a second priority of any one performance indicator may take precedence over a violation of the first priority of another performance indicator. A violation of a first priority may generate a warning while the violation of a second priority may generate an alert.

An alarm may be presented to a user in a variety of ways, including through input/output circuitry 240. Each of a warning, an alert, and a stop may be presented differently. In various embodiments, a warning may generate an indicator, such as an indicator light or indicator icon on a user interface. An alert may generate an alert message, which may be presented on an indicator light or on a user interface. A stop may generate a message and/or a signal, and the message may be presented to a user (e.g., by a user interface) and the signal may be send to the battery 100, battery module 110, battery cells 120, and/or equipment 160 drawing power from the battery 100 to stop one or more operations.

Having generally described embodiments in accordance with the present invention, several exemplary operations according to exemplary embodiments will be described.

### Exemplary Operations

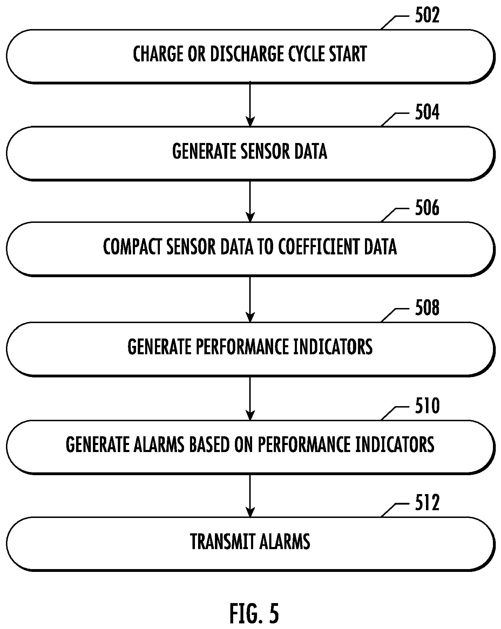

In some example embodiments, and according to the operations described herein, the controller 150 may be used to monitor and manage a battery 100, battery module 110, and/or battery cell 120, including controlling a battery 100, battery module 110, and/or battery cell 120. FIGS. 5-7 illustrate flowcharts associated with various operations associated with such battery monitoring and managing.

While the following flowcharts and description include multiple operations, it is readily appreciated that some of the following operations may be omitted, some of the operations may be repeated or iterated, and that additional operations may be included. Additionally, the order of operations should not be interpreted as limiting as the order of these operations may be varied.

FIG. 5 illustrates a flowchart according to an example method for monitoring and managing batteries in accordance with one or more embodiments of the present disclosure.

At operation 502, a charge of discharge cycle starts. As a charge cycle or discharge cycle starts, power will be transferred to a battery 100 or from a battery 100. This transfer of power, including heat generated during the transfer of power, may be measured with the sensors 140.

At operation 504, sensor data is generated. Sensor data is generated by sensors 140 during the charge cycles and discharge cycles. The sensor data may include measurements taken from any of the sensors 140, including temperature sensor(s), voltage sensor(s), and current sensor(s). In various embodiments, the sensor data may be provided as a data stream to the controller 150. In various embodiments, the sensors 140 may generate one or more sensor data objects containing the sensor data, which may be provided to the controller 150. A data object may include additional information tagged to the sensor data.

In various embodiments, the start of a charge or discharge cycle may be determined by the receipt of sensor data tagged with an identifier, such as cycle identifier. For example, an identifier in sensor data received may include an identifier of charge cycle 5 while an analogous identifier in previously received sensor data may have included an identifier of a discharge cycle 4. The change in identifier may indicate the start of a new cycle, such as a charge cycle in this example. Alternatively, or additionally, a charge cycle or a discharge cycle may be determined by the value of one or more coefficients, which may change from positive to negative, such as a coefficient associated with current changing from positive to negative to indicate the direction current may be flowing. Alternatively, or additionally, a directional change in coefficient associated with voltage may indicate that the voltage is increasing or decreasing after having, respectively, been decreasing or increasing, which may be determined to indicate that charging or discharging is occurring.

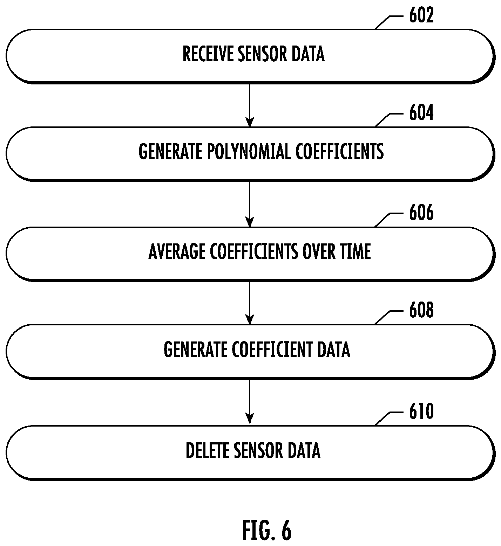

At operation 506, sensor data is compacted to coefficient data. Having received the sensor data, a controller 150 may compact the sensor data into coefficient data as described herein, including as described here and in regard to FIG. 6.

At operation 508, performance indicators are generated. Having compacted the sensor data into coefficient data, performance indicators may be generated from the coefficient data as described herein. In various embodiment, the controller may generate performance data in real-time as coefficient data is generated. Performance indicators may be generated from the coefficient data for a current cycle being compared to a respective reference coefficient as well as coefficient data associated from one or more prior cycles.

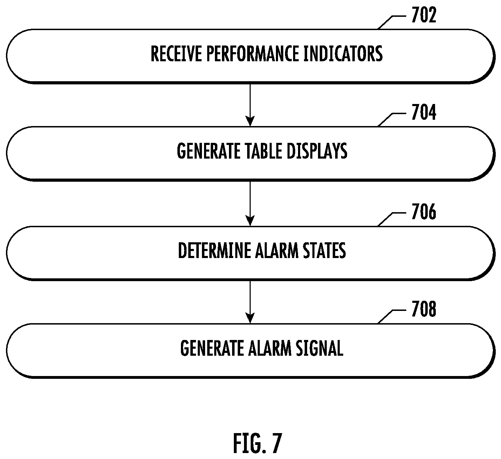

At operation 510, alarms are generated based on performance indicators. Having received the performance indicators, a controller 150 may generate one or more alarms of warnings, alerts, and/or stops based on the performance indicators, including as described herein and in regard to FIG. 7.

At operation 512, alarms are transmitted. The controller 150, having generated one or more alarms, may transmit the one or more alarms as appropriate. In various embodiments, warnings, alerts, and stop signals may be transmitted to a user interface as well as to a battery 100, battery module 110, and/or battery cells 120 as appropriate. In various embodiments, a battery controller 150 may transmit an alarm to a battery module controller 150 to control one or more battery modules 110 and/or battery cells 120, such as to stop the operation of a battery module 110 and/or battery cell 120 and/or to operate one or more switches associated with a battery module 110 and/or a battery cell 120.

FIG. 6 illustrates a flowchart according to an example method for compacting sensor data in accordance with one or more embodiments of the present disclosure.

At operation 602, sensor data is received. The sensor data may be generated by one or more sensors 140 and transmitted from one or more sensors 140 to a controller 150. The sensor data may be received by a controller 150 in real-time or at time intervals, such as with a sensor data object containing sensor data for a cycle. In various embodiments, the sensor data may be received in a sensor data object that includes a batch of sensor data for an entire charge cycle and/or discharge cycle, which may include a batching of sensor measurements at a plurality of times.

At operation 604, polynomial coefficients are generated. In various embodiments, a polynomial equation with coefficients is solved within a predefined error rate to generate polynomial coefficients as described herein. The coefficients may be generated for each time period of data received or on a continuous basis as sensor data is received.

At operation 606, the coefficients are averaged over time. In various embodiments with a data stream of sensor data being received by the controller 150 in real-time, the incoming sensor data is continuously fine tuning coefficients of a polynomial equation and averaging the coefficients. Alternatively, as sensor data is received for at time intervals the coefficients may be averaged as they are generated by on the time interval.

At operation 608, coefficient data is generated. As coefficients for a cycle are determined from a polynomial equation and averaged over time, the coefficients for a cycle are determined. Once the sensor data for a cycle has been received the coefficients for the cycle are determines, the coefficients for the cycle will no longer change and the coefficient data may be generated, which may include storing the coefficient data in a coefficient data object.

At operation 610, sensor data is deleted. After coefficient data is generated for a cycle, the sensor data may be deleted or overwritten. In various embodiments, this may include tagging the sensor data with one or more flags that indicates the sensor data may be overwritten in memory.

FIG. 7 illustrates a flowchart according to an example method for generating alarms in accordance with one or more embodiments of the present disclosure.

At operation 702, performance indicators are received. The performance indicators may be received as they are generated, and the performance indicators may be stored in a performance indicators data objects. The performance indicators data object may be updated as additional performance indicators are generated. After performance indicators are received, one or more tables for display may be generated and/or one or more alarm states may be determined, which may occur serially or in parallel.

At operation 704, table displays are generated. Based on the performance indicators, one or more tables, such as those of FIGS. 4A & 4B may be generated. The table displays may be generated from performance indicators stored in a performance indicators data object. In various embodiments, tables may be generated before, after, or as a part of determining one or more alarm states. The table displays may be presented to a user one a user interface.

At operation 706, alarm states are determined. The alarm states may include warnings, alerts, and stops as described herein. These alarm states may be based one or more priorities as described herein.

At operation 708, alarm signals are generated. Alarms signals may be generated based on the alarm states. The alarm signals for the alarm states may cause an alarm to be presented to a user, stop the battery 100, battery modules 110, and/or battery cells 120 from powering equipment 160, and/or stop equipment 160 from using a battery 100 as described herein. In various embodiments, a controller 150 may generate an alarm message to communicate an alarm to a user on a user interface. The controller 150 may cause the alarm message to be rendered on the user interface after the alarm message has been generated. In various embodiments, the alarm signals may be transmitted to one or more equipment to alarm the equipment 160, which may include presenting an alarm message to a user on a user interface of the equipment 160 and/or to stop one or more operations of the equipment 160. In various embodiments, the alarm signals, such as a stop signal, may be transmitted from the controller 150 to the battery 100, battery module 110, and/or battery cell 120 to operate one or more switch or component of the battery 100, battery module 110, and/or battery cell 120 to cease one or more operations or the providing of power by the battery 100, battery module 110, and/or battery cell 120.

Operations of the present invention have been described in flowcharts. As will be appreciated, computer program instructions may be loaded onto a computer or other programmable apparatus (e.g., hardware) to produce a machine, such that the resulting computer or other programmable apparatus implements the functions and/or operations described in the flowchart blocks herein. These computer program instructions may also be stored in a computer-readable memory that may direct a computer or other programmable apparatus to function in a particular manner, such that the instructions stored in the computer-readable memory produce an article of manufacture, the execution of which implements the functions and/or operations described in the flowchart blocks. The computer program instructions may also be loaded onto a computer or other programmable apparatus to cause a series of operations to be performed on the computer or other programmable apparatus to produce a computer-implemented process such that the instructions executed on the computer or other programmable apparatus provide operations for implementing the functions and/or operations specified in the flowchart blocks. The flowchart blocks support combinations of means for performing the specified functions and combinations of operations for performing the specified functions and/or operations. It will be understood that one or more blocks of the flowcharts, and combinations of blocks in the flowcharts, can be implemented by special purpose hardware-based computer systems which perform the specified functions and/or operations, or combinations of special purpose hardware with computer instructions.

While this specification contains many specific embodiments and implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

While operations are illustrated in the drawings in a particular order, this should not be understood as requiring that such operations be performed in the particular order shown or in sequential order, or that all illustrated operations be performed, to achieve desirable results. In certain circumstances, operations in alternative ordering may be advantageous. In some cases, the actions recited in the claims may be performed in a different order and still achieve desirable results. Thus, while particular embodiments of the subject matter have been described, other embodiments are within the scope of the following claims.

## Claims

1. A system for battery (100) monitoring and managing comprising:
a battery (100);
a plurality of sensors (140) electrically coupled to the battery and configured to generate sensor data associated with the battery, wherein the plurality of sensors include at least a temperature sensor, a voltage sensor, and a current sensor, and wherein the sensor data includes temperature sensor data generated by the temperature sensor, voltage sensor data generated by the voltage sensor, and current sensor data generated by the current sensor;
a controller (150) electrically coupled to the plurality of sensors, wherein the controller is configured to:
receive sensor data from the plurality of sensors;
compact the sensor data into coefficient data, based on a polynomial equation;
generate one or more performance indicators based on the coefficient data; and
generate at least one alarm based on the performance indicators.

2. The system of claim 1, wherein the controller (150) is further configured to transmit the at least one alarm to a user interface and cause the alarm to be rendered on a user interface.

3. The system of claim 1, wherein the performance indicators include a deviation rate.

4. The system of claim 1, wherein the controller (150) is further configured to:
generate a table of performance indicators for display on a user interface; and
render the table on the user interface.

5. A method for battery (100) monitoring and managing comprising:
generating, with a plurality of sensors (140), sensor data associated with a battery, wherein the plurality of sensors are electrically coupled to the battery, wherein the plurality of sensors include at least a temperature sensor, a voltage sensor, and a current sensor, and wherein the sensor data includes temperature sensor data generated by the temperature sensor, voltage sensor data generated by the voltage sensor, and current sensor data generated by the current sensor;
receiving, at a controller (150), the sensor data from the plurality of sensors;
compacting the sensor data into coefficient data, based on a polynomial equation;
generating one or more performance indicators based on the coefficient data; and
generating at least one alarm based on the performance indicators.

6. The method of claim 5 further comprising:
transmitting the at least one alarm to a user interface and cause the alarm to be rendered on a user interface.

7. The method of claim 5, wherein the performance indicators include a deviation rate.

8. The method of claim 5 further comprising:
generating a table of performance indicators for display on a user interface; and
rendering the table on the user interface.

9. A computer program product for battery (100) monitoring and managing, the computer program product comprising at least one non-transitory computer-readable storage medium having computer-readable program code portions stored therein, the computer-readable program code portions comprising an executable portion configured to:
receive, from a plurality of sensors (140), sensor data associated with a battery, wherein the plurality of sensors are electrically coupled to the battery, wherein the plurality of sensors include at least a temperature sensor, a voltage sensor, and a current sensor, and wherein the sensor data includes temperature sensor data generated by the temperature sensor, voltage sensor data generated by the voltage sensor, and current sensor data generated by the current sensor;
receive, at a controller (150), the sensor data from the plurality of sensors;
compact the sensor data into coefficient data, based on a polynomial equation;
generate one or more performance indicators based on the coefficient data; and generating at least one alarm based on the performance indicators.

10. The computer program product of Claim 9, wherein the computer-readable program code portions comprising an executable portion are further configured to:
transmit the at least one alarm to a user interface and cause the alarm to be rendered on a user interface.

11. The computer program product of Claim 9, wherein the performance indicators include a deviation rate.

12. The computer program product of Claim 9, wherein the computer-readable program code portions comprising an executable portion are further configured to:
generate a table of performance indicators for display on a user interface; and
render the table on the user interface.

## Patentansprüche

1. System zum Überwachen und Verwalten einer Batterie (100), umfassend:
eine Batterie (100);
eine Vielzahl von Sensoren (140), die elektrisch mit der Batterie gekoppelt und dazu konfiguriert sind, Sensordaten zu erzeugen, die der Batterie zugehörig sind, wobei die Vielzahl von Sensoren mindestens einen Temperatursensor, einen Spannungssensor und einen Stromsensor beinhaltet, und wobei die Sensordaten von dem Temperatursensor erzeugte Temperatursensordaten, von dem Spannungssensor erzeugte Spannungssensordaten und von dem Stromsensor erzeugte Stromsensordaten beinhalten;
eine Steuerung (150), die elektrisch mit der Vielzahl von Sensoren gekoppelt ist, wobei die Steuerung dazu konfiguriert ist:
Sensordaten von der Vielzahl von Sensoren zu empfangen;
die Sensordaten auf Basis einer Polynomgleichung in Koeffizientendaten zu verdichten;
auf Basis der Koeffizientendaten einen oder mehrere Leistungsindikatoren zu erzeugen; und
auf Basis der Leistungsindikatoren mindestens einen Alarm zu erzeugen.

2. System nach Anspruch 1, wobei die Steuerung (150) ferner dazu konfiguriert ist, den mindestens einen Alarm an eine Benutzerschnittstelle zu übertragen und zu veranlassen, dass der Alarm auf einer Benutzerschnittstelle wiedergegeben wird.

3. System nach Anspruch 1, wobei die Leistungsindikatoren eine Abweichungsrate beinhalten.

4. System nach Anspruch 1, wobei die Steuerung (150) ferner dazu konfiguriert ist:
eine Tabelle von Leistungsindikatoren zur Anzeige auf einer Benutzerschnittstelle zu erzeugen; und
die Tabelle auf der Benutzerschnittstelle wiederzugeben.

5. Verfahren zum Überwachen und Verwalten einer Batterie (100), umfassend:
Erzeugen, mit einer Vielzahl von Sensoren (140), von Sensordaten, die einer Batterie zugehörig sind, wobei die Vielzahl von Sensoren elektrisch mit der Batterie gekoppelt sind, wobei die Vielzahl von Sensoren mindestens einen Temperatursensor, einen Spannungssensor und einen Stromsensor beinhaltet, und wobei die Sensordaten von dem Temperatursensor erzeugte Temperatursensordaten, von dem Spannungssensor erzeugte Spannungssensordaten und von dem Stromsensor erzeugte Stromsensordaten beinhalten;
Empfangen, an einer Steuerung (150), der Sensordaten von der Vielzahl von Sensoren;
Verdichten der Sensordaten in Koeffizientendaten auf Basis einer Polynomgleichung;
Erzeugen eines oder mehrerer Leistungsindikatoren auf Basis der Koeffizientendaten; und
Erzeugen mindestens eines Alarms auf Basis der Leistungsindikatoren.

6. Verfahren nach Anspruch 5, ferner umfassend:
Übertragen des mindestens einen Alarms an eine Benutzerschnittstelle und Veranlassen, dass der Alarm auf einer Benutzerschnittstelle wiedergegeben wird.

7. Verfahren nach Anspruch 5, wobei die Leistungsindikatoren eine Abweichungsrate beinhalten.

8. Verfahren nach Anspruch 5, ferner umfassend:
Erzeugen einer Tabelle von Leistungsindikatoren zur Anzeige auf einer Benutzerschnittstelle; und
Wiedergeben der Tabelle auf der Benutzerschnittstelle.

9. Computerprogrammprodukt zum Überwachen und Verwalten einer Batterie (100), wobei das Computerprogrammprodukt mindestens ein nichttransitorisches computerlesbares Speichermedium umfasst, das darauf gespeicherte computerlesbare Programmcodeabschnitte aufweist, wobei die computerlesbaren Programmcodeabschnitte einen ausführbaren Abschnitt umfassen, der dazu konfiguriert ist:
von einer Vielzahl von Sensoren (140) Sensordaten zu empfangen, die einer Batterie zugehörig sind, wobei die Vielzahl von Sensoren elektrisch mit der Batterie gekoppelt sind, wobei die Vielzahl von Sensoren mindestens einen Temperatursensor, einen Spannungssensor und einen Stromsensor beinhaltet, und wobei die Sensordaten von dem Temperatursensor erzeugte Temperatursensordaten, von dem Spannungssensor erzeugte Spannungssensordaten und von dem Stromsensor erzeugte Stromsensordaten beinhalten;
an einer Steuerung (150) die Sensordaten von der Vielzahl von Sensoren zu empfangen;
die Sensordaten auf Basis einer Polynomgleichung in Koeffizientendaten zu verdichten;
auf Basis der Koeffizientendaten einen oder mehrere Leistungsindikatoren zu erzeugen; und
auf Basis der Leistungsindikatoren mindestens einen Alarm zu erzeugen.

10. Computerprogrammprodukt nach Anspruch 9, wobei die computerlesbaren Programmcodeabschnitte, die einen ausführbaren Abschnitt umfassen, ferner dazu konfiguriert sind:
den mindestens einen Alarm an eine Benutzerschnittstelle zu übertragen und zu veranlassen, dass der Alarm auf einer Benutzerschnittstelle wiedergegeben wird.

11. Computerprogrammprodukt nach Anspruch 9, wobei die Leistungsindikatoren eine Abweichungsrate beinhalten.

12. Computerprogrammprodukt nach Anspruch 9, wobei die computerlesbaren Programmcodeabschnitte, die einen ausführbaren Abschnitt umfassen, ferner dazu konfiguriert sind:
eine Tabelle von Leistungsindikatoren zur Anzeige auf einer Benutzerschnittstelle zu erzeugen; und
die Tabelle auf der Benutzerschnittstelle wiederzugeben.

## Revendications

1. Système de surveillance et de gestion de batterie (100) comprenant :
une batterie (100) ;
une pluralité de capteurs (140) couplée électriquement à la batterie et configurée pour générer des données de capteur associées à la batterie, dans laquelle la pluralité de capteurs inclut au moins un capteur de température, un capteur de tension et un capteur de courant, et dans laquelle les données de capteur incluent des données de capteur de température générées par le capteur de température, des données de capteur de tension générées par le capteur de tension, et des données de capteur de courant générées par le capteur de courant ;
un contrôleur (150) couplé électriquement à la pluralité de capteurs, dans lequel le contrôleur est configuré pour :
recevoir des données de capteur provenant de la pluralité de capteurs ;
compacter les données de capteur en données de coefficient, sur la base d'une équation polynomiale ;
générer un ou plusieurs indicateurs de performance sur la base des données de coefficient ; et
générer au moins une alarme sur la base des indicateurs de performance.

2. Système selon la revendication 1, dans lequel le contrôleur (150) est en outre configuré pour transmettre l'au moins une alarme à une interface utilisateur et faire en sorte que l'alarme soit affichée sur une interface utilisateur.

3. Système selon la revendication 1, dans lequel les indicateurs de performance incluent un taux de déviation.

4. Système selon la revendication 1, dans lequel le contrôleur (150) est en outre configuré pour :
générer un tableau d'indicateurs de performance destiné à être affiché sur une interface utilisateur ; et
afficher le tableau sur l'interface utilisateur.

5. Procédé de surveillance et de gestion de batterie (100) comprenant :
la génération, au moyen d'une pluralité de capteurs (140), de données de capteur associées à une batterie, dans laquelle la pluralité de capteurs est couplée électriquement à la batterie, dans laquelle la pluralité de capteurs inclut au moins un capteur de température, un capteur de tension et un capteur de courant, et dans laquelle les données de capteur incluent des données de capteur de température générées par le capteur de température, des données de capteur de tension générées par le capteur de tension, et des données de capteur de courant générées par le capteur de courant ;
la réception, au niveau d'un contrôleur (150), des données de capteur provenant de la pluralité de capteurs ;
le compactage des données de capteur en données de coefficient, sur la base d'une équation polynomiale ;
la génération d'un ou plusieurs indicateurs de performance sur la base des données de coefficient ; et
la génération d'au moins une alarme sur la base des indicateurs de performance.

6. Procédé selon la revendication 5, comprenant en outre :
la transmission de l'au moins une alarme à une interface utilisateur et le fait de faire en sorte que l'alarme soit affichée sur une interface utilisateur.

7. Procédé selon la revendication 5, dans lequel les indicateurs de performance incluent un taux de déviation.

8. Procédé selon la revendication 5, comprenant en outre :
la génération d'un tableau d'indicateurs de performance destiné à être affiché sur une interface utilisateur ; et
l'affichage du tableau sur l'interface utilisateur.

9. Produit de programme d'ordinateur pour la surveillance et la gestion de batterie (100), le produit de programme d'ordinateur comprenant au moins un support de stockage non transitoire lisible par ordinateur ayant des portions de code de programme lisibles par ordinateur stockées dans celui-ci, les portions de code de programme lisibles par ordinateur comprenant une portion exécutable configurée pour :
recevoir, en provenance d'une pluralité de capteurs (140), des données de capteur associées à une batterie, dans lequel la pluralité de capteurs est couplée électriquement à la batterie, dans lequel la pluralité de capteurs inclut au moins un capteur de température, un capteur de tension et un capteur de courant, et dans lequel les données de capteur incluent des données de capteur de température générées par le capteur de température, des données de capteur de tension générées par le capteur de tension, et des données de capteur de courant générées par le capteur de courant ;
recevoir, au niveau d'un contrôleur (150), les données de capteur provenant de la pluralité de capteurs ;
compacter les données de capteur en données de coefficient, sur la base d'une équation polynomiale ;
générer un ou plusieurs indicateurs de performance sur la base des données de coefficient ; et
générer au moins une alarme sur la base des indicateurs de performance.

10. Produit de programme d'ordinateur selon la revendication 9, dans lequel les portions de code de programme lisibles par ordinateur comprenant une portion exécutable sont en outre configurées pour :
transmettre l'au moins une alarme à une interface utilisateur et faire en sorte que l'alarme soit affichée sur une interface utilisateur.

11. Produit de programme d'ordinateur selon la revendication 9, dans lequel les indicateurs de performance incluent un taux de déviation.

12. Produit de programme d'ordinateur selon la revendication 9, dans lequel les portions de code de programme lisibles par ordinateur comprenant une portion exécutable sont en outre configurées pour :
générer un tableau d'indicateurs de performance destiné à être affiché sur une interface utilisateur ; et
afficher le tableau sur l'interface utilisateur.
